# EUROPEAN PATENT APPLICATION

(11) **EP 0 906 945 A1**
(43) Date of publication of application: **07.04.1999**
(21) Application number: 98116672.1
(22) Date of filing: 03.09.1998
(51) Int. Cl.: C09K 5/00, H01L 23/373

(54) **Sprayable thermal grease**

(30) Priority: 03.10.1997 US 943826
(71) Applicant: American Oil and Supply LLC, Newark, NJ 07105 (US)
(72) Inventor: Ziemski, John, Newark, NJ 07105 (US); Khatri, Prakash, Newark, NJ 07105 (US)
(74) Representative: Denmark, James

(57) **Abstract**

A thermal grease mixture is disclosed. Thermal greases are used as heat sink components in various electrical and electronic devices. The thermal grease mixture disclosed is combined with a solvent that decreases the viscosity of the grease so that it takes a liquid form and can be applied through a spray.

## Description

### FIELD OF THE INVENTION

The present invention relates in general to the field of thermal grease. Thermal grease is a product used as a heat sink material in the electronics field. The present invention focuses on a new technique for applying thermal grease that eliminates problems with the prior methods of application. The present invention is directed to a method whereby the thermal grease can be applied to electronic components by spraying. The present invention is directed to use with any of the commercially available thermal greases with various different methods of spray application including, but not limited to, manual spray pump, aerosol, pressurized or pneumatic. In particular, the present invention is directed toward adding a solvent to the thermal grease compound to achieve a liquid form that is readily adapted to the spray application technique.

### BACKGROUND OF THE INVENTION

The present invention relates to the field of thermal grease. Thermal grease has been used in the electronics industry for many years since the introduction of electronics. Thermal grease is generally made in the form of a thick white paste and is used to dissipate heat or transfer heat between electronic components. Since the introduction of thermal grease, the basic formula has been modified slightly to alter or improve its thermal performance. For example, 100% synthetic non-silicone based formulas eliminated the problems of creep, contamination, and separation that are common in silicone-based products. Different fillers have been used to achieve faster rates of thermal transfer or thermal conductivity.

There are a number of disadvantages to the current form of thermal grease. First, the method of applying thermal grease to the electronic components is labor intensive. Application of the thermal grease can be time consuming, messy, and difficult to clean-up afterwards. In addition, due to the high viscosity of the thermal grease, it is very difficult to achieve a coating of the grease that is of uniform thickness. In addition, the application of the thermal grease must be done in such a manner to prevent contamination by the thermal grease flowing over the edge of the electronic components. Water soluble thermal grease as well as automated dispensing systems are two prior methods that have been used to address these problems. However, even these two methods have not proven entirely satisfactory and design engineers have often turned to other alternatives. These alternatives include such things as thermal pads, thermally conductive adhesives, or making design changes to eliminate the heat in other ways. These alternatives are preferred because of the manufacturing efficiencies they offer such as easy application, convenience and a cleaner application.

The rise of microelectronics has presented new problems that are not satisfactorily solved by the alternatives. Due to the very small size of the current electronic components, the thermal interface material must be applied in a very thin film. The thermal grease can be applied in a thickness of less than ½ mil while the thermal pads are generally much thicker. In addition, due to the decreased size and increased speed of electronic components, much more heat is generated so that a low thermal resistance of the heat sink material is crucial to removing the heat from the components. The advantage to thermal grease is that it fills the microscopic air gaps and eliminates the resistance to heat flow from the air that would normally fill those gaps. Thus, the thermal grease provides the best thermal transfer by providing the quickest heat flow away from the components.

Because of the aforementioned problems with the application of thermal grease as well as the heat flow problems with the alternatives to thermal grease, there is a long felt need for a thermal grease that can be consistently applied to electronics in a manner that eliminates the prior problems and allows the thermal grease to maintain its superior thermal performance in operation.

### SUMMARY OF THE INVENTION

The present invention is directed to thermal grease containing a solvent that results in a low viscosity grease in liquid form. The mixture of thermal grease and solvent exhibits thermal properties that are equivalent to or greater than commercially available thermal greases and that can be modified according to individual specifications. Due to the liquid form, the grease may be applied to electronic components by a spray system thereby depositing a thin film of grease of uniform thickness to the component. The process of spraying on the thermal grease eliminates the labor intensiveness and mess of current manual and automated dispensing systems for thermal grease. In addition, the spray system produces a consistently even film of grease over the component while using less material. The spray system also allows for grease deposition within predefined parameters. In manual applications, a stencil is required to achieve the same type of parameters.

Although the thermal grease of the present invention was developed for application to electronic components in particular, the uses of the present invention are not so limited. Rather, the thermal grease is a general heat sink material that can be used in all types of electrical devices where heat must be removed during operation. For example, it is contemplated that the thermal grease of the present invention is particularly well suited as a heat transfer mechanism between the heating element of a hot plate and the heated surface thereof.

An object of the present invention is to provide a heat sink compound in a liquid form adapted to be applied to electronic components by a spray application without compromising the superior thermal properties and thermal stability of the thermal grease. Another object is to provide a heat sink compound that can be applied in a thin film of uniform thickness over the electronic components. In addition, the method of application has the object of reducing the amount of material used per application. Another object of the invention is to create a method of application that eliminates the mess and clean up time required by current methods of thermal grease application.

### DETAILED DESCRIPTION OF THE INVENTION

The present invention is directed to conventional thermal grease that is mixed with a solvent. Thermal greases are well known to those of ordinary skill in the art and can be of the silicone or non-silicone variety such as those sold under the name AOS Heat Sink Compounds.

It has been discovered that if conventional thermal greases are mixed with solvents that the viscosity of the grease will be dramatically decreased to the point where the grease assumes a liquid form. When the grease assumes this form, it can readily be adapted to be applied by means of spraying as further explained herein. After the grease is sprayed onto the area of application, the solvent quickly evaporates and the grease returns to its normal highly viscous consistency.

It has also been determined that the best solvent materials are light hydrocarbon distillates. In particular, it has been determined that either heptane or hexane provide the best performance when mixed with the grease. The particular mixtures of solvent and thermal grease required vary depending on the contemplated method of application. It is contemplated that there are two general methods of dispensing and applying the grease.

The first general method of application is by packaging the grease and solvent in a conventional aerosol spray can. In this method, as is well known to those of ordinary skill in the art, a propellant is required as well as the solvent and grease. It has been determined that the propellant does not affect the thermal performance of the grease to any significant extent. The second general method for application is by maintaining the grease and solvent mixture in its liquid state in a pressurized container and then apply the mixture through well known methods of spraying pressurized liquids through spray nozzles.

In the aerosol application method, the preferred solvent is heptane. The proportions of components in the mixture used for this type of application is: thermal grease in the range of 30 to 40% by weight, heptane in the range of 10 to 20% by weight, and 30 to 40% propellant. The propellant used in this combination is isobutane. The components can be mixed and packaged into aerosol cans by any of the conventional methods known to those of ordinary skill in the art.

In the second method of application, either heptane or hexane may be used as the solvent. In this application, a leveling agent, glycol ether is also used. The leveling agent serves to prevent evaporation of the solvent at too rapid of a rate. If the solvent evaporates from the mixture too quickly, bubbling will occur on the outer surface which is undesirable because it will leave an uneven surface. The proportions of components in the mixture used for this type of application is: thermal grease in the range of 40 to 50% by weight, heptane or hexane in the range of 50 to 60% by weight, and 1 to 5% of the leveling agent. This mixture is then packaged in a suitable container at a pressure of 25 to 80psi.

Those of ordinary skill in the art will recognize that the embodiments just described merely illustrate the principles of the present invention. Many modifications may be made thereto without departing from the spirit and scope of the invention as set forth in the following claims.

## Claims

1. A thermally conductive grease mixture adapted to be dispensed in an aerosol application comprising thermal grease, a solvent and a propellant.

2. The thermally conductive grease mixture of Claim 1 wherein the solvent comprises heptane and the propellant comprises isobutane.

3. The thermally conductive grease mixture of Claim 2 wherein the percentage of thermal grease in the mixture is in the range of about 30 to about 40% by weight.

4. The thermally conductive grease mixture of Claim 3 wherein the percentage of heptane in the mixture is in the range of about 10 to about 20% by weight

5. The thermally conductive grease mixture of Claim 4 wherein the percentage of isobutane is about 30 to about 40% by weight.

6. A thermally conductive grease mixture adapted to be dispensed by means of a liquid spray comprising thermal grease, a solvent and a leveling agent.

7. The thermally conductive grease mixture of Claim 6 wherein the solvent comprises heptane or hexane and the leveling agent comprises glycol ether.

8. The thermally conductive grease mixture of Claim 7 wherein the percentage of thermal grease in the mixture is in the range of about 40 to about 50% by weight.

9. The thermally conductive grease mixture of Claim 8 wherein the percentage of heptane or hexane in the mixture is in the range of about 50 to about 60% by weight.

10. The thermally conductive grease mixture of Claim 9 wherein the percentage of glycol ether is about 1 to about 5% by weight.
